Europäisches Patentamt

European Patent Office

Office européen des brevets

(11) Publication number: **0 403 061**

**A2**

# (12) EUROPEAN PATENT APPLICATION

(21) Application number: 90304570.6

(51) Int. Cl.5: **G06F 15/60**

(22) Date of filing: 26.04.90

The title of the invention has been amended (Guidelines for Examination in the EPO, A-III, 7.3).

(30) Priority: 27.04.89 JP 110493/89
01.05.89 JP 112587/89
01.05.89 JP 112588/89

(43) Date of publication of application:
19.12.90 Bulletin 90/51

(84) Designated Contracting States:
DE FR GB NL

(71) Applicant: KAWASAKI STEEL CORPORATION
No. 1-28, 1-Chome Kitahonmachi-Dori
Chuo-Ku, Kobe-Shi Hyogo 651(JP)

(72) Inventor: Marui, Tomohiro
3-7-5 Fuchuu-cho, Fuchuu-shi
Tokyo 183(JP)
Inventor: Ishida, Yoshihiro
1-14-8 Minami-cho, Chiba-shi
Chiba 280(JP)
Inventor: Oka, Hiroyuki
2-20-6, Minami-cho, Chiba-shi
Chiba 280(JP)

(74) Representative: Stebbing, Timothy Charles et al
Haseltine Lake & Co. Hazlitt House 28
Southampton Buildings Chancery Lane
London WC2A 1AT(GB)

(54) **A single-board computer incorporating programmable logic devices and its use in the automatic implementation and testing of logic circuits.**

(57) There is provided a programmable one-board computer (30) comprising a system board (32) including wiring , one or more microprocessor chips (34) disposed at the centre of the system board, and a plurality of programmable logic devices (PLD) (36) disposed to surround the microprocessor chip(s). Each said PLD may include a memory (38) for defining an internal circuit thereof or may substitute partly for an external memory device. The PLDs may comprise large scale PLDs (36A) as inner PLDs thereof and small scale PLDs (36B) as outer PLDs. The programmable one-board computer (30) can realize an actual circuit altered from a newly designed logic circuit (20) and laid out on the same. The actual circuit laid on the same can be used for verification.

## FIG. 2

## Programmable one-board computer, and methods of verification of logic circuit and alteration to actual circuit using the programmable one-board computer

The present invention relates to a programmable one-board computer, and methods of verification of a logic circuit and of alteration to an actual circuit using the programmable one-board computer.

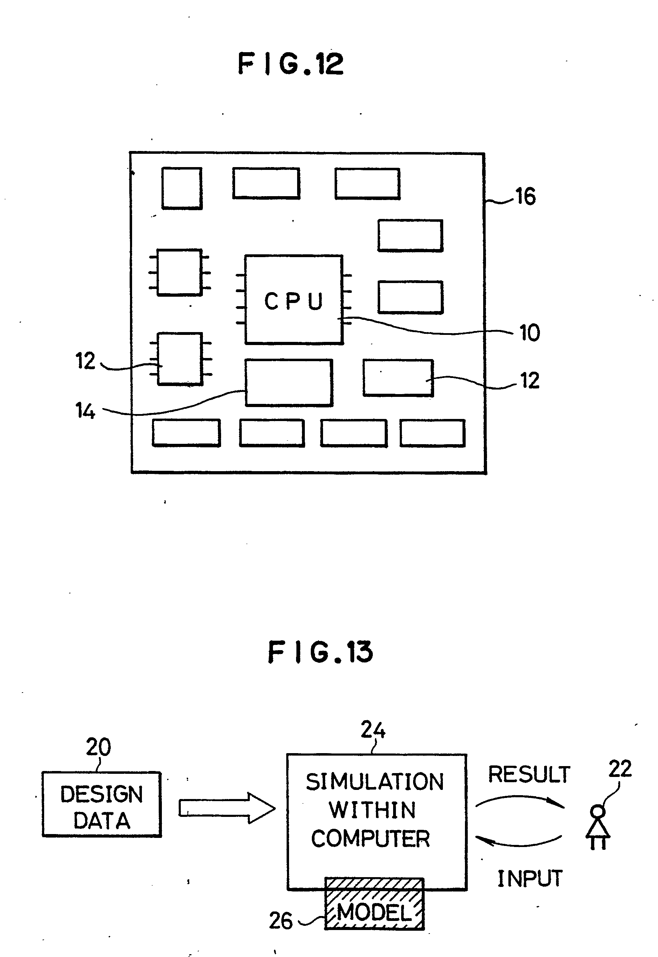

In a prior one-board computer there are disposed on a system board 16 in combination for each system design as illustrated in Fig. 12 for example, a chip 10 of a central microprocessor, varieties of general purpose ICs 12 such as TTLs, RAMs, ROMs, etc., and a peripheral circuit composed of a very small number of programmable logic devices (PLD) 14 for use in decoding of any address and so on.

Such a prior one-board computer after having once been assembled is therefore impossible to be reconfigured to another circuit for other applications.

Additionally, when a newly designed logic circuit is altered to an actual circuit on the one-board computer, there can not be utilized any data as to the prior one-board computer that is design property, and a new design must be done over again from the beginning each time it is needed.

Further, an LSI (large scale integrated circuit) includes many constituent parts with complicated relationships thereamong. Therefore, a designer can substantially not predict all results in each design process. Moreover, even in a prototype process of such a design, any wrong design produces very high cost. For reducing the possibility of such very costly errors as far as possible, there has increased a demand for a computer tool with which a designer can analyze and verify a designed circuit prior to manufacture of silicon that is very expensive.

The prior practice to design an IC is as follows:

1) the stem of an abstract idea in designers thoughts,

2) the step of architecture specifications (register transfer level (RTL)) that is a combination of black boxes for example,

3) the step of a schematic logical design (gate level) that is a combination of circuit blocks for example,

4) the step of a circuit design (transistor level) that is a combination of transistor circuits for example, and

5) the step of a mask layout on silicon.

The practice also includes a design step of testing of any fault of a finished product.

Accordingly, in order to design a large-scale system and realize it with a combination of actual large scale integrated circuit, said verification is very important to check whether or not the design is reflected properly at various steps of the practice.

In the prior verification process there are various design steps. In the first step where the abstract idea is existent in designer's thoughts, a designer performs the verification by himself in his thoughts. Then, in the successive RTL level, the designer likewise performs the verification in his thoughts or performs functional simulation by computation through a logic simulator with the aid of a computer. Also in the successive gate level, the designer performs functional simulation by computation through a logic simulator with the aid of a computer. In the next transistor level, a timing analysis by computation is performed through a timing simulator with the aid of a computer. Additionally, in the mask layout step, a circuit is extracted from themask data using a computer for which a timing analysis is computed through a timing simulator. Furthermore, for the final step of testing, fault simulation is performed through a fault simulator using test vectors (test patterns). The test vectors are prepared by the designer with the aid of a computer.

In the prior verification process, however, a design circuit (design data) 20 actually not existent in a computer 24 is chiefly modeled, and the computer 24 evaluates for simulation of the resulting model 26. Therefore, for a logic simulation for 10000 gates for example which is performed by an 1MIPS machine, verification thereof requires a time exceeding one hour, and for logic simulation beyond a transistor level, much more time is required. Additionally, since a designer 22 inputs a design circuit 20 into the computer 24 in the form of a model, wrong verifications may occur. Further. timing and so on do not satisfactorily correspond to actual situations.

In order to estimate whether a test vector for verification is adequate or not, it is necessary to intentionally produce internal failures such as element failure or disconnection failure in various portions of a modelled logic circuit for examination of a failure detection rate, etc. by the test vector (in a circuit for which no failure detection is taken into consideration, the rate might be 70% or less in a simple, uncomplicated failure, and in a circuit where failure detection is taken into consideration about 95% or more in a similar simple failure.) However, in a system wherein failures are produced one by one in each portion of a modelled logic circuit to each of which test vectors are generated by computation, it is necessary to repeat computation for each failure. Therefore, even a test vector that takes about three seconds for example for its operation requires a time of up to weeks for the above computation in order to accurately estimate a failure detection rate.

Additionally, for obtaining an output pattern as a reference for comparison when an input pattern for a device under testing (DUT input pattern) is inputted into the device, similar computation is required taking a long period of time as well

Alternatively, there is known another technique as disclosed in Japanese Laid-Open Publication Nos. 62-93736 and 63-157072, wherein, particularly in the latter, use of a hardware simulator instead of the software simulator described above is made to check the operation of an LSI. the hardware simulator being prepared by specifying a necessary integrated circuit module and writing code data corresponding to logic specifications into a PLD of the specified integrated circuit module.

The hardware simulator, however, includes ICs arranged regularly such as PLDs, EPROMs, and RAMs, etc., into which varieties of serial IC modules can be optionally incorporated including many other IC modules that might be unnecessary depending upon the associated logic circuit, resulting in a complicated structure thereof.

In view of the drawbacks with the prior art, it is desirable to provide a programmable one-board computer capable of accepting versatile systems and allowing alteration of such a system rapidly and with ease.

An embodiment of the present invention may provide a method of altering logic circuit to an actual circuit capable of altering with ease a designed logic circuit to an actual circuit including a PLD with use of design property on combinations of actual circuits of PLDs and corresponding partial circuits that have already been designed.

An embodiment of the present invention may provide a method of verification of a logic circuit, the method being capable of verification and estimation of a designed logic circuit and a test vector of the same, etc., for a short period of time in each design step using a verification circuit actually realized with use of a PLD.

An embodiment of the present invention may assure rapid estimation of a test vector with use of an actual verification circuit.

An embodiment of the present invention may assure rapid preparation of an output pattern when a DUT input pattern is inputted, using an actual verification circuit.

In accordance with one aspect of the present invention, a programmable one-board computer comprises a system board including wiring, at least one microprocessor chip disposed substantially at the centre of said system board, and a plurality of programmable logic devices disposed to substantially surround the circumference of said microprocessor chip.

Likewise, a programmable one-board computer comprises a system board including wiring, at least one microprocessor chip disposed substantially at the centre of said system board, and a plurality of large scale programmable logic devices each disposed to substantially surround the circumference of said microprocessor chip, and a plurality of small scale programmable logic devices each disposed outside said large scale programmable logic devices.

The programmable one-board computer can further comprise a memory device for defining the internal circuit of each said programmable logic device.

Part of said programmable logic devices can include a memory for a computer system.

A memory device for a computer system can also be provided.

In accordance with another aspect of the present invention, a method of alteration from a designed logic device to an actual circuit including a programmable logic devices, e.g. in a one-board computer as specified above, comprises the steps of dividing said logic circuit into partial circuits, estimating actual circuits of programmable logic devices corresponding to said partial circuits utilizing a data base in which there are stored many combinations of actual circuits of the programmable logic devices corresponding to the partial circuits which have already been designed, and laying out the estimated actual circuits on a one-board computer to alter the whole logic circuit to an actual circuit.

In accordance with another aspect of the present invention, a method of verification of a logic circuit comprises the steps of altering a designed logic circuit to a circuit of a programmable logic device, realizing the altered circuit as an actual verification circuit including programmable logic devices e.g. in a one-board computer as specified above, and verifying said logic circuit using the circuit realized as the verification circuit.

In a method of the present invention, a rapid estimation can be made of a test vector for fault simulation using said circuit realized as the verification circuit.

In addition, rapid preparation of an output pattern can achieved by creating an output pattern from said logic circuit when a DUT input pattern is inputted, using said circuit realized as the verification circuit.

In the present invention, a plurality of programmable logic devices substantially surround the circumference of at least one microprocessor disposed substantially at the centre of a system board, whereby almost all the peripheral circuits of an existing one-board computer are transplanted onto a programmable logic device which is capable of erasing/reconfiguration of such a circuit.

The present invention can therefore accept a versatile system as well as accept system alteration etc, rapidly and with ease. Accordingly, the present invention is preferable for use in testing devices and the like upon development of new function digital semiconductor integrated circuits such as new single chip microcomputers, etc., and is also useful for other applications, of course.

Additionally, when said programmable logic devices are hierarchically structured, and small scale programmable logic devices are disposed outside large scale programmable logic devices, the programmable one-board computer of the present invention is preferable for hierarchy control and hierarchy-structure systems.

Moreover, when there are provided memory devices for defining an internal circuit of said programmable logic device, the memories are unnecessary.

Furthermore, when part of said programmable logic devices includes a memory for a computer system, an external memory device is unnecessary. This assures high speed operation.

Moreover, when there is provided a memory device for a computer system, it is unnecessary for a programmable logic device to include a computer system memory.

In use of the invention, data for an ordinary exclusive computer board is utilized as design property, and many combinations of PLD actual circuits corresponding to partial circuits which have already been designed are stored in a data base. A designed logic circuit is divided into partial circuits, and PLD actual circuits corresponding to those partial circuits are estimated using said data base and laid out to alter the whole logic circuit to an actual circuit. Hereby, an actual circuit including a PLD can easily be established utilizing conventional design property.

Particularly, when said actual circuit is realized on a programmable one-board computer including at least one microprocessor chip disposed substantially at the centre of a system board and a plurality of PLDs disposed to substantially surround the circumference of said microprocessor chip, the logic circuit can easily be laid out on said programmable one-board computer for realization of said actual circuit.

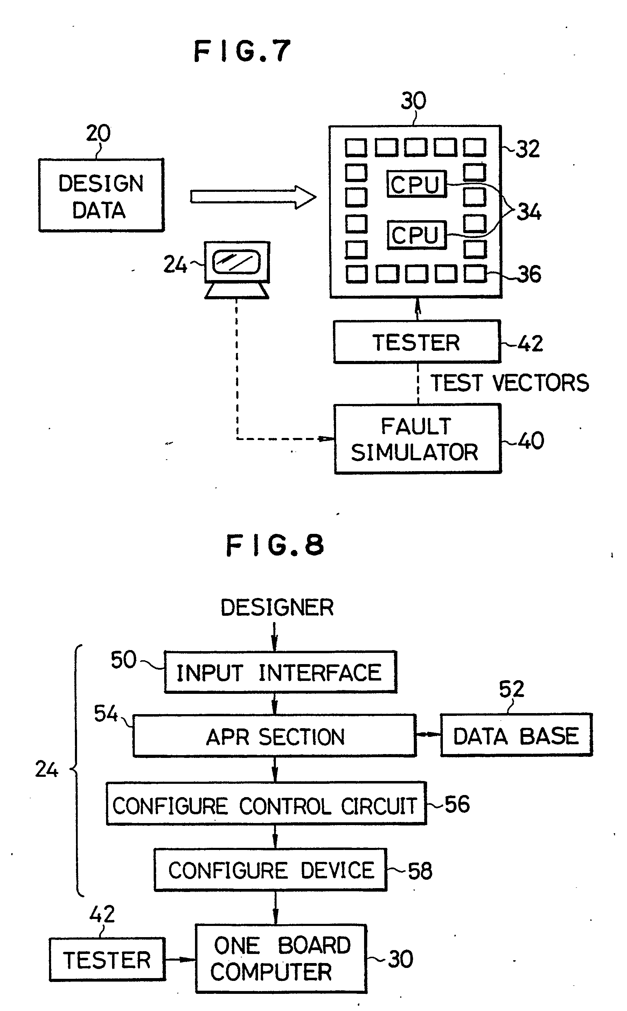

In a method of the present invention (e.g. see Fig. 7), a designed logic circuit (design data) 20 is altered to a programmable logic device (PLD) circuit by using a development tool 24 for example, which is then realized as an actual verification circuit including a PLD, for example, a programmable one-board computer 30 which includes at least one (two in the figure) microprocessor (CPU) chip 34 disposed substantially at the centre of a system board 32 and a plurality of PLDs 36 disposed to substantially surround the circumference of said CPU chip 34. The realized circuit as the verification circuit (30) is then used to verify the function and timing, etc., of said logic circuit 20 with use of a tester 42 into which test vectors are inputted from a fault simulator 40 for example. Thus, the logic circuit 20 is realized as the verification circuit (30) of a simple structure for verification work on an actual circuit. Therefore, any verification can be performed in real time much quicker than computation and hence the verification work can rapidly be completed. Since an actual circuit is used in particular, the possibility of wrong verification is sharply reduced. Additionally, the use of the circuit of a programmable logic device simplifies the whole construction and facilitates any alteration of a designed logic circuit to a verification circuit.

When said programmable one-board computer 30 is used as the verification circuit, an arbitrary verification circuit can be realized with particular ease.

For logic circuits 20 of the present invention, i.e. , for design data, data is made available by a flow chart method proposed by Mr. Nick Tredennck (refer to COMPUTER, 81, 12, PP 87 to 102). The flow chart method is a procedure to design a computer process, and available data with use of an arbitrary operation descriptive language. Additionally, if we consider the aforesaid gate level, there is available schematic data representative of a combination of circuit blocks for example. At the aforesaid transistor level, there is available data of a transistor circuit diagram for example. At the aforesaid mask layout level, there is available circuit data by a combination of circuit elements extracted from a mask layout for example.

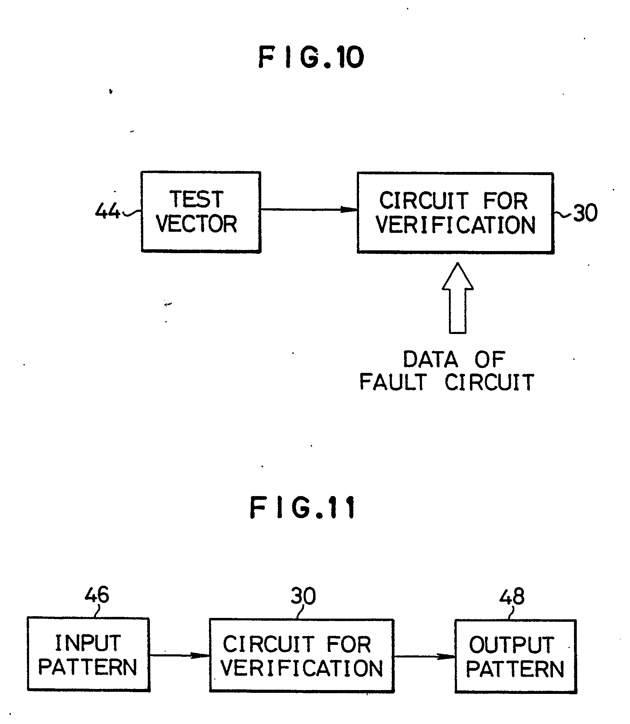

Moreover, regarding a testing level, there are available product test data (test vectors 44) created by an arbitrary method from arbitrary stage design data, for example created by a simulation engine, a fault simulator, and a test vector generator, etc. , for example. More specifically, since a circuit where any trouble has been arbitrarily produced can be implemented into an actual machine (30) as shown in Fig. 10, operation time of test vectors in units of seconds or minutes can be estimated in real time.

Therefore, even a final stage test vector that conventionally took over one week can quickly be estimated and created.

Furthermore, as illustrated in Fig. 11, an output pattern 48 of a device tested using an input pattern (DUT input pattern) 46 can also be prepared very rapidly in real time.

Reference is made, by way of example, to the accompanying drawings, in which like reference characters designate the same or similar parts throughout the figures thereof and wherein:

Fig. 1 is a plan view illustrating the arrangement of a first embodiment of a programmable one-board computer according to the present invention;

Fig. 2 is a plan view illustrating the arrangement of a second embodiment of the same;

Fig. 3 is a plan view illustrating the arrangement of a third embodiment of the same;

Fig. 4 is a diagram illustrating the hierarchy structure of the third embodiment;

Fig. 5 is a plan view illustrating the arrangement of a fourth embodiment of the present invention;

Fig. 6 is a diagram schematically illustrating a method of alteration of a logic circuit to an actual circuit according to the present invention;

Fig. 7 is a diagram schematically illustrating the method of alteration to a verification circuit as an exemplary actual circuit realized by the present invention, and illustrating a verification method using the resulting verification circuit;

Fig. 8 is a block diagram exemplarily illustrating the arrangement of an apparatus for performing the alteration to an actual circuit according to the present invention;

Fig. 9 is a diagram exemplarily illustrating a data base provided in the apparatus;

Figs. 10 and 11 are diagrams each schematically illustrating the method of verification of a logic circuit according to the present invention;

Fig. 12 is a plan view illustrating the arrangement of a prior one-board computer; and

Fig. 13 is a diagram schematically illustrating a prior verification process.

In what follows, preferred embodiments of the present invention will be described with reference to the accompanying drawings.

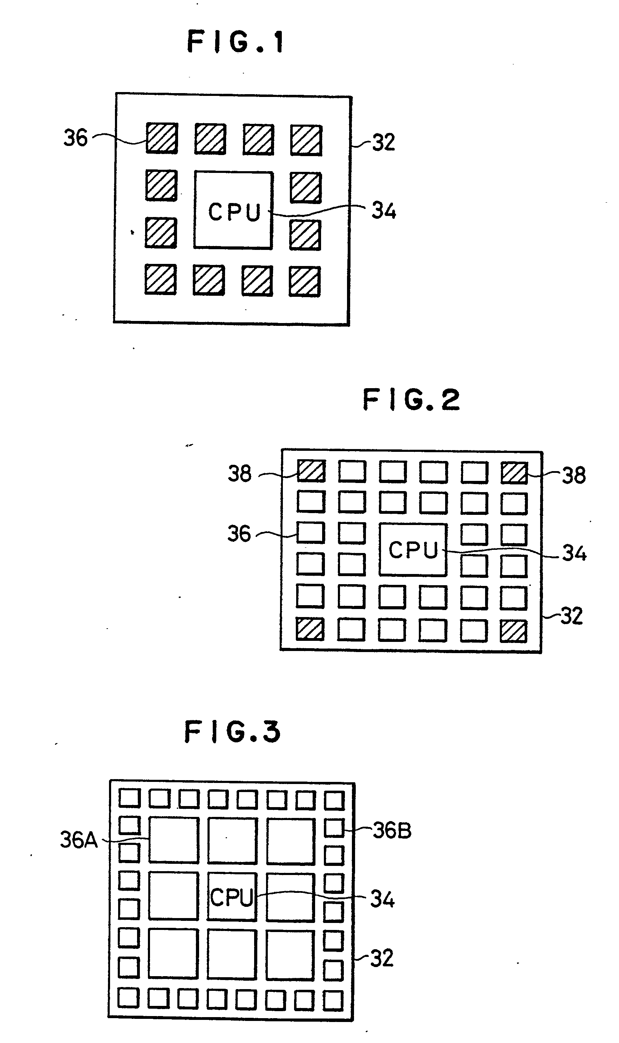

A first embodiment of a programmable one-board computer according to the present invention comprises, as illustrated in Fig. 1, a system board 32 including wiring (not shown), a single microprocessor (CPU) chip 34 disposed substantially at the centre of the system board 32, and a plurality of (12 in the figure) programmable logic devices (PLD) 36 disposed to substantially surround the circumference of the microprocessor chip 34.

In the first embodiment, there is included in the PLD 36 memory (SRAM and EPROM, for example) for defining an internal circuit of the PLD. Therefore, the embodiment can accept a versatile system by defining the memory while matching it with such a system using an external development tool. Additionally, the embodiment can accept such a system rapidly and easily by also rewriting the memory when the system is altered.

In the present embodiment, since the PLD includes the memory for defining the internal circuit thereof, no external memory device is required in the system board 32, allowing very simple construction and flexibility.

Next, a second embodiment of the programmable one-board computer of the present invention will be described with reference to Fig. 2.

In the second embodiment, in a similar one-board computer to that in the first embodiment, the number of PLDs 36 is increased, eg doubled, to surround the CPU chip 34, and external memory devices for defining the internal circuits of the PLDs, PROMs 38 for example, instead of beings part of the PLDs, are disposed in the four corners in the present embodiment.

The present embodiment can provide a versatile system by defining the internal circuit of the PLD by the PROM 38.

In the present embodiment, since the external PROM 38 is provided on the system board 32, the operation is rather effective depending on an associated system.

In the following, a third embodiment of the programmable one-board computer of the present invention will be described with reference to Fig. 3.

The third embodiment comprises a system board 32 and a CPU chip 34 similar to those in the first embodiment, a plurality of (8 in the present case) large scale programmable logic devices (PLD) 36A disposed to substantially surround the circumference of the CPU chip 34, and a plurality of (28 in the present case) small scale PLDs 36B disposed outside the large scale PLDs 36A.

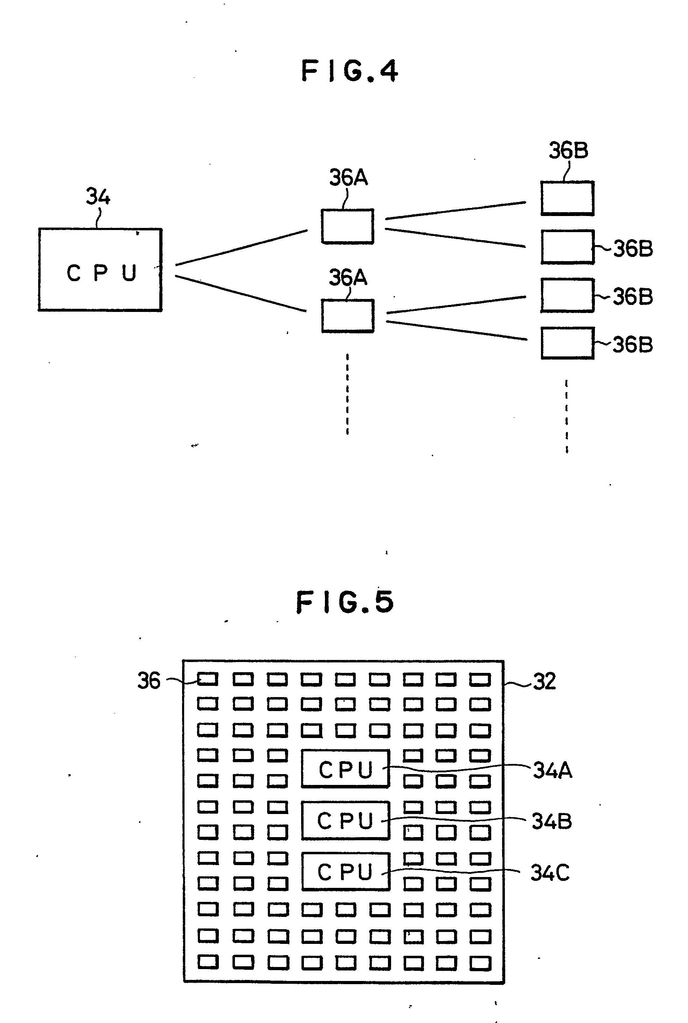

The present embodiment facilitates, as illustrated in Fig. 4 for example, circuit definition of a construction that corresponds to large and small size PLDs connected in a hierarchy (hierarchical) structure, the so-called hierarchy design. Particularly, this includes a structure large-sized circuit such as a co-processor circuit which is directly coupled to a CPU and receives from and delivers to the CPU at a high speed for executing partial data processing jointly with the CPU. The circuit may therefore be defined within the large scale PLD 36A. In the present embodiment, the large scale PLD 36A is located in the vicinity of the CPU chip 34 so that the embodiment is capable of high speed operation with high efficiency and is preferable for a hierarchy structure system.

In this third embodiment, it is possible of course that part of the large scale PLD 36A or the small scale PLD 36B is replaced by the same PROM 38 as that in the second embodiment.

Next, a fourth embodiment of the programmable one-board computer of the present invention will be described with reference to Fig. 5.

In the fourth embodiment, in a similar one-board computer to that in the first embodiment, there are provided a plurality of CPU chips (three of 34A, 34B, and 34C in the figure) by changing makers and a bit number such as 8, 16, and 32 bits, etc., for example.

In accordance with the present embodiment, makers and a bit number of the CPU chip are selectable in proper conformity with the system, allowing a board size to be increased but improving flexibility of the embodiment.

Although in the above embodiments, as the microprocessor chips 34, 34A, 34B, and 34C, there were used those including memories and I/O circuits, etc., which are commercially available, a microprocessor chip may also be used which only includes a centre core without such memories and I/O circuits, etc.

In this case, the circumferential PLDs can be available for memories and I/O circuits, etc., included in a typical microprocessor. This case is therefore advantageous particularly to the development of CPUs. Herein, there may be provided, independently on the system board 32, peripheral circuits of the microprocessor that are difficult to be constructed as PLDs, such as A/D converter, D/A converter, DC/DC converter, ELD (Electronic Luminescence Display) driver, power failure detection circuit, multiplier, FFT processor, and cash (cache) tag memory

Additionally, for the foregoing PLDs 36, 36A, and 36B, those including a computer system memory may be useable. This situation assures fast access and hence high speed operation, because the PLD includes there in a computer system memory. It is of course possible to provide external computer system memories such as DRAMs and ROMs on the system board 32 independently of the PLDs.

Successively, embodiments of a method of alteration to an actual circuit and a verification method according to the present invention will be described with an example wherein a verification circuit is laid on a programmable one-board computer to verify a newly designed logic circuit.

In the present embodiment, as illustrated in Fig. 7, a designed logic circuit (design data) 20 is altered to a programmable logic device (PLD) circuit using a development tool 24 which is then realized as an actual verification circuit including a PLD, e.g., a programmable one-board computer 30 that includes at least one (two in the figure) microprocessor (CPU) chip 34 disposed substantially at the centre of the system board 32 and a plurality of the PLDs 36 disposed to substantially surround the circumference of the CPU chip 34.

The circuit realized as the verification circuit (30) is used for verification of the function and timing, etc., of the logic circuit 20 through a tester 42 into which a test vector is inputted from a fault simulator 40.

For alteration to an actual circuit and verification of a logic circuit according to the present invention, as illustrated in Fig. 8 for example, the development tool 24 is used. The development tool 24 comprises an input interface unit 50 into which a logic circuit designed by a designer is inputted, a data base 52 in which there is stored much alteration data of combinations of conventional partial circuits which have already been designed and PLD actual circuits, an APR (Automatic Placement Router) section 54 for altering a logic circuit inputted from the input interface unit 50 to actual circuits of PLDs based upon the data stored in the data base 52, and a configuration control circuit 56 and a configuration device 58 for realizing the circuit altered by the APR section 54 as an actual verification circuit including PLDs, the aforementioned programmable one-board computer 30, for example.

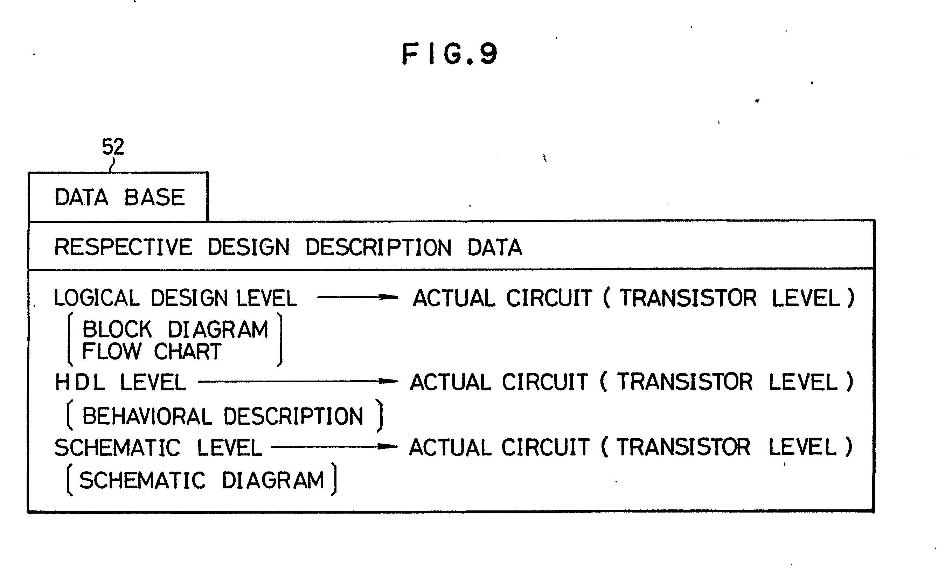

In the data base 52, as illustrated in Fig. 9, a large volume of data is stored in the form of libraries as design property for each corresponding partial circuit, such data including combinations of: designs of prior partial (peripheral) circuits in respective design steps: for example, a logical design level including block diagrams, flow charts, state transition tables, and state transition maps, etc., a hardware description language (HDL) level including function description expressed by definition formulae including a code representative of the current status and a code representative of the next status, and a schematic level including a schematic diagram expressed by symbols, and of: data on transistor level PLD circuits obtained by realizing the aforementioned designs of the prior partial circuits, the combinations of designs of prior partial circuits and of data about transistor level PLD circuits, consisting e.g. of which microprocessor is used and how many microprocessors are used, what peripheral chips (memory, TTL, PLD, and the like) are used and how many peripheral chips are used, and how they are wired and connected, and so on.

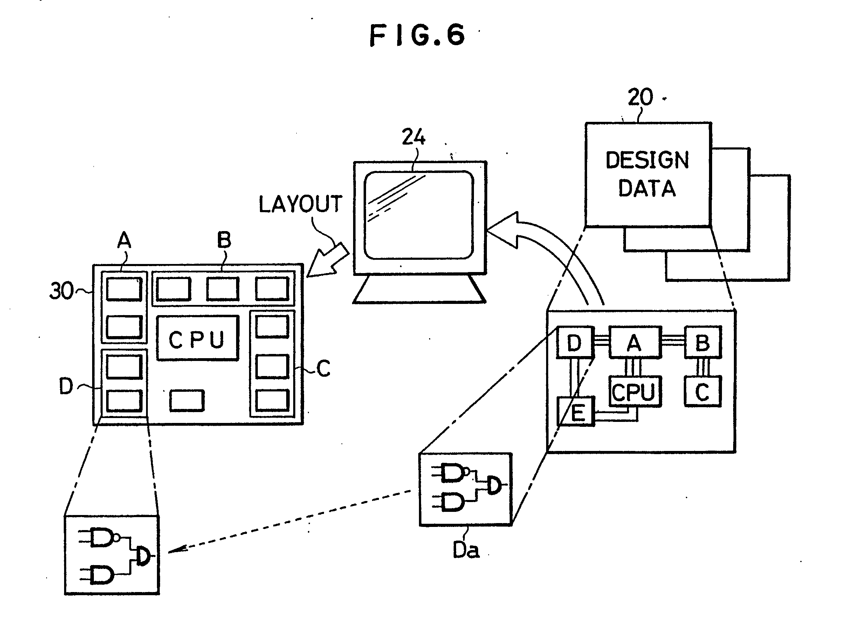

Accordingly, the calculating section 54 selectively takes out from the data base 52 actual circuits Da, ... corresponding to the partial circuits A, B, C, D and E obtained by dividing up input logic circuit 20 and lays them out on the PLDs in the one-board computer 30, to determine the arrangement and wiring of the logic circuit, as illustrated in Fig. 6.

Herein, upon the alteration to an actual circuit, logical design level data for example may sometimes be difficult to alter directly to an actual circuit. To solve this, the data maybe lowered once to the HDL level which may then be altered to an actual circuit.

Thus, a test signal is inputted into the verification circuit realized on the programmable one-board computer 30 through the tester 42, whereby real time verification work is achieved with use of the actual circuit.

Additionally, for estimating a fault detection rate, etc., of test vectors, failure data circuits, which are obtained by intentionally producing internal failures such as bad elements and disconnections, are employed instead of the design data to realize the failure circuit on the one-board computer 30, into which the test vector is inputted to estimate rapidly in real time the fault detection rate, etc., of the test vector, as illustrated in Fig. 10.

Furthermore, for preparing an output pattern corresponding to a test pattern, the test pattern is inputted into a verification circuit realized on the one-board computer 30 to obtain rapidly in real time a corresponding output pattern, as illustrated in Fig. 11. Therefore, any combination of such input and output patterns can be obtained with ease.

As described above, the logic circuit 20 is realized as a verification circuit for verification of an actual circuit so that the verification is achievable in real time, much more quickly than computation to ensure rapid verification work. In particular, use of an actual circuit sharply reduces the possibility of any mistakes. In addition, use of a programmable logic device circuit facilitates alteration of a designed logic circuit to an actual circuit. Use of the programmable one-board computer 30 as a device for realization of an actual circuit ensures realization of an arbitrary actual circuit with ease. More specifically, the PLD 36 for example includes therein a memory (SRAM or EPROM, for example) for defining an internal circuit thereof, whose memory is then defined after an associated system using the development tool 24. Thereby, the programmable one-board computer can accept a versatile system. Further, even if the system is changed, the programmable one-board computer can accept such a change rapidly and easily by rewriting the above memory.

In the present embodiment, the memory for defining an internal circuit of a PLD is included in the PLD, so that the need to provide external memory devices in the system board 32 is eliminated, resulting in a very simple and flexible construction.

Additionally, in the above described embodiment, as means to realize an actual circuit there is provided a one-board computer 30 composed of two CPU chips and many PLDs, and makers (types) for those CPU chips and a bit number of the same are selectable as required to emulate an associated system, resulting in very high flexibility of the device, although there no limitation to the types of one-board computers for realizing any actual circuit.

For example, in the foregoing modification illustrated in Fig. 2, the number of the PLDs 36 may be further increased around the CPU 34, e.g. doubled, and external memories for defining the internal circuit of the PLD 36, (e.g., the PROMs 38) instead of being part of the PLDs may be disposed in the four corners of the board. Alternatively, as in another modification illustrated in Fig. 3, there may be provided a plurality (8 in the Figure) of large scale programmable logic devices (PLDs) 36A disposed to substantially surround the CPU 34 and a plurality (28 in the Figure) of small scale PLDs 36B disposed around the large scale PLDs 36A.

Thus, as described above, there is provided a programmable one-board computer (3) comprising a system board (32) including wiring, one or more microprocessor chips (34) disposed at the centre of the system board, and a plurality of programmable logic devices (PLDs) (36) disposed to surround the microprocessor chip(s). Each PLD may include a memory (38) for defining an internal circuit thereof or may substitute partly for an external memory device. The PLDs may comprise large scale PLDs (36A) as inner PLDs and small scale PLDs (36B) as outer PLDs. The programmable one-board computer (30) can realize an actual circuit altered from a newly designed logic circuit (20) and laid out on the same. The actual circuit can be used for verification.

The programmable one-board computer is capable of accepting varieties of systems and of accepting alterations of those systems quickly and easily by making use of a programmable logic device (PLD), the internal circuit of which is erasable/reconfigurable.

## Claims

1. A programmable one-board computer comprising:

(a) a system board (32) including wiring ;

(b) at least one microprocessor chip (34) disposed substantially at the centre of said system board; and

(c) a plurality of programmable logic devices (36) each disposed to substantially surround said microprocessor chip.

2. A programmable one-board computer comprising:

(a) a system board (32) including wiring;

(b) at least one microprocessor chip (34) disposed substantially at the centre of said system board;

(c) a plurality of large scale programmable logic devices (36A) disposed to substantially surround the circumference of said microprocessor chip; and

(d) a plurality of small scale programmable logic devices (36B) disposed outside said large scale programmable logic devices.

3. A programmable one-board computer according to claim 1 or 2, wherein it further comprises memory devices (38) for defining internal circuits of said programmable logic device.

4. A programmable one-board computer according to claim 1, wherein said programmable logic devices (36, 36A; 36B) partly include memory for a computer system.

5. A programmable one-board computer according to any preceding claim, wherein it further comprises memory devices (38) for a computer system.

6. A method of alteration of a designed logic circuit to an actual circuit, said actual circuit including programmable logic devices comprising the steps of:

(a) dividing said logic circuit into partial circuits (A, B, C, D, E);

(b) estimating actual circuits of programmable logic devices corresponding to said partial circuits utilizing a data base (52) in which there are stored many combinations of actual circuits of programmable logic devices corresponding to the partial circuits which have already been designed, and

(c) laying out the estimated actual circuits to alter the whole logic circuit to an actual circuit (30).

7. A method of verification of a logic circuit comprising the steps of:

(a) altering a designed logic circuit (20) to a programmable logic device circuit;

(b) realizing the altered circuit to an actual circuit (30) for verification including programmable logic devices; and

(c) verifying said logic circuit using the circuit realized as said circuit for verification.

8. A method of verification of a logic circuit according to claim 7, wherein a test vector (44) for fault simulation is estimated using said circuit (30) realized as said verification circuit.

9. A method of verification of a logic circuit according to claim 7 or 8, wherein an output pattern (48) from said logic circuit is generated when input patterns (46) for device under testing are inputted to said circuit (30) realized as the circuit for verification.

FIG.1

FIG.2

FIG.3

EP 0 403 061 A2

# FIG.4

# FIG.5

# FIG.6

LAYOUT

EP 0 403 061 A2

# FIG.7

DESIGN DATA 20

24

30
32
34
36

CPU
CPU

TESTER ~42

TEST VECTORS

FAULT SIMULATOR ~40

# FIG.8

DESIGNER

50 ~ INPUT INTERFACE

54 ~ APR SECTION

52
DATA BASE

CONFIGURE CONTROL CIRCUIT ~56

24

CONFIGURE DEVICE ~58

42
TESTER

ONE BOARD COMPUTER ~30

# F I G.9

EP 0 403 061 A2

**52**

| DATA BASE |
| --- |
| RESPECTIVE DESIGN DESCRIPTION DATA |

LOGICAL DESIGN LEVEL ———➤ ACTUAL CIRCUIT ( TRANSISTOR LEVEL )

[ BLOCK DIAGRAM
FLOW CHART ]

HDL LEVEL ——————➤ ACTUAL CIRCUIT ( TRANSISTOR LEVEL )

[ BEHAVIORAL DESCRIPTION ]

SCHEMATIC LEVEL ————➤ ACTUAL CIRCUIT ( TRANSISTOR LEVEL )

[ SCHEMATIC DIAGRAM ]

# F I G.10

```
44 ──┐  ┌──────────┐              ┌──────────────┐
     │  │   TEST   │              │  CIRCUIT FOR │  ─30
        │  VECTOR  │ ──────────▶  │ VERIFICATION │
        └──────────┘              └──────────────┘
                                         ▲
                                         │
                                   DATA  OF
                                 FAULT  CIRCUIT
```

# F I G.11

```
      46                  30                    48
  ┌──────────┐      ┌──────────────┐      ┌──────────┐
  │  INPUT   │      │  CIRCUIT FOR │      │  OUTPUT  │
  │ PATTERN  │ ───▶ │ VERIFICATION │ ───▶ │ PATTERN  │
  └──────────┘      └──────────────┘      └──────────┘
```

# FIG.12

# FIG.13